# EUROPÄISCHE PATENTSCHRIFT

(11) **EP 2 162 803 B1**
(45) Veröffentlichungstag und Bekanntmachung des Hinweises auf die Patenterteilung: **29.07.2015**
(21) Anmeldenummer: 08760703.2
(22) Anmeldetag: 09.06.2008
(51) Int. Cl.: G05B 17/02, G01M 17/00, G06F 17/50

(54) **VORRICHTUNG UND VERFAHREN ZUR SIMULATION EINER ENTWICKLUNGSANLAGE FÜR EINEN PRÜFSTAND**
DEVICE AND METHOD FOR SIMULATING A DEVELOPMENTAL ARRANGEMENT FOR A TEST STAND
DISPOSITIF ET PROCÉDÉ DE SIMULATION D'UN ÉQUIPEMENT DE DÉVELOPPEMENT POUR UN BANC D'ESSAI

(30) Priorität: 14.06.2007 AT 36607 U
(43) Veröffentlichungstag der Anmeldung: 17.03.2010
(73) Patentinhaber: AVL List GmbH, 8020 Graz (AT)
(72) Erfinder: WALENTA, Mario, A-8010 Graz (AT); KLOECKL, Martin, A-8430 Gralla (AT); KRAINZ, Manfred, A-8045 Graz (AT)
(74) Vertreter: Patentanwälte Pinter & Weiss OG
(86) Internationale Anmeldenummer: PCT/EP2008/057134
(87) Internationale Veröffentlichungsnummer: WO 2008/152010

(56) Entgegenhaltungen:
- WO-A-00/41050
- US-A1- 2006 225 710
- ISERMANN R ET AL: "Design of computer controlled combustion engines" MECHATRONICS, PERGAMON PRESS, OXFORD, GB, Bd. 13, Nr. 10, 1. Dezember 2003 (2003-12-01), Seiten 1067-1089, XP004448736 ISSN: 0957-4158
- HANSELMANN H: "REAL-TIME SIMULATION REPLACES TEST DRIVES" TEST AND MEASUREMENT WORLD, REED BUSINESS INFORMATION, HIGHLANDS RANCH, CO, US, Bd. 16, Nr. 3, 15. Februar 1996 (1996-02-15), Seite 35/36,38,40, XP000559454 ISSN: 0744-1657

## Beschreibung

Die gegenständliche Erfindung betrifft eine Vorrichtung und ein Verfahren zur Simulation der Konfiguration und des Arbeitsablaufes in einer Entwicklungsumgebung, die eine Entwicklungsanlage für einen Prüfstand für einen Prüfling und eine Simulationseinrichtung umfasst, wobei in der Entwicklungsanlage eine reale Automatisierungseinrichtung zum Betrieb des Prüfstandes vorgesehen ist, der Prüfstand und der Prüfling in der Simulationseinrichtung mittels eines Simulationsdaten erzeugenden Prüfmodells nachgebildet sind und die Automatisierungseinrichtung und die Simulationseinrichtung über reale Schnittstellen der Entwicklungsanlage verbunden sind und die Automatisierungseinrichtung erzeugte Simulationsdaten verarbeitet.

Aus dem Stand der Technik, insbesondere aus "Real-Time Simulation Replaces Test Drives", H. Hanselmann, Test and Measurement World, Reed Business Information, Highlands Ranch, Bd. 16, Nr. 3, 15, 2, 1996, Seiten 35, 36, 38, 40, sind sogenannte Hardware-In-The-Loop (HIL) Simulatoren für die ECU-Entwicklung bekannt. In einem solchen HIL-Simulator wird die reale ECU mit bestimmten Daten, z.B. für die ABS-Entwicklung Radgeschwindigkeiten, aus einem Modell des Fahrzeugs versorgt. Das Fahrzeug selbst ist dabei auf einem Prüfstand aufgebaut, wobei ECU Ein- und Ausgänge über den Echtzeitsimulator umgeleitet werden. Damit werden für HIL-Simulatoren ein realer Prüfstand und auch der Prüfling selbst benötigt.

(Weiter-)Entwicklungen von Motoren, Getrieben, Motorsträngen, oder ganzer Fahrzeuge, bzw. Teilen davon, werden in der Regel auf speziellen Prüfständen, wie z.B. Motorprüfständen, Rollenprüfständen, etc., gemacht. Diese Prüfstände werden dabei von eigenen Automatisierungssystemen, wie z.B. die PUMA-Familie des Anmelders, gesteuert und geregelt, wobei neben der manuellen Steuerung natürlich auch vollautomatische Testläufe generierbar und exekutierbar sind. Solche Prüfstände sind aber sehr komplexe technische Einrichtungen welche durch entsprechende Konfiguration und Parametrierung auf die jeweilige Anwendung angepasst werden müssen. Dadurch wird für jede Anwendung eine eigene Konfiguration der benötigten Komponenten, wie Prüfstands-HW und -SW, Messgeräte, Indiziertechnik, Datenerfassung und -auswertung, Entwicklungswerkzeuge, etc., benötigt. Der Aufwand wird noch dadurch erhöht, dass heutzutage mehrere Prüfstände parallel im Einsatz stehen (Prüffabriken) und parallel Prüfungsaufgaben abgewickelt werden. Das Einrichten oder die Neukonfiguration eines Prüfstandes und insbesondere ganzer Prüffabriken bedingt daher einen enormen Aufwand, der sich beim Betreiber in tagelangen Stillstandszeiten bemerkbar macht. Alleine schon das Einspielen einer neuen SW-Version, z.B. der Automatisierungs-SW, stellt schon ein Risiko dar, da nicht abgeschätzt werden kann, ob alle Prüfstandskomponenten dann noch einwandfrei zusammenspielen und funktionieren.

Eine andere Problematik liegt im Erstellen von Prüfabläufen, wobei schon einfache neue Prüfabläufe aufgrund der Komplexität der Anlagen bei der Umsetzung beim Betreiber erhebliche Probleme bereiten können. Das Erstellen und Testen von Prüfabläufen direkt am realen Prüfstand ist daher ebenfalls ein kostenintensiver und aufwendiger Vorgang.

Auch die notwendige Schulung von Bedienpersonal ist auf realen Prüfständen nicht wirtschaftlich möglich, da dazu entweder ein eigener (teurer) Schulungsprüfstand vorhanden sein muss oder ein Prüfstand nicht produktiv betrieben werden kann. Außerdem müsste für jede Konfiguration eine Schulungsmöglichkeit vorhanden sein.

Es ist daher wünschenswert Simulatoren einzusetzen, mittels derer ein Prüfstand simuliert werden kann.

Dazu ist aus der WO 00/41050 A1 ein Testgerät für industrielle Automatisierungssysteme einer technischen Anlage bekannt. Dieses Testgerät erlaubt es, die technische Anlage zu modellieren und mit der realen Steuerungsumgebung zu verbinden. Damit kann eine konfigurierbare technische Anlage im Verbund mit der Steuerungsumgebung simuliert werden. Die technische Anlage wird dabei in Form von Antworten bestimmter Anlagenteile auf Steuerungssignale der Steuerungsumgebung modelliert. Dies ermöglicht es folglich real vorhandene Regelungsschleifen über einen Simulator, auf dem die Modelle laufen, zu schließen. Damit kann das Verhalten eines Automatisierungssystems einer technischen Anlage vorab getestet werden. Auch die Schulung des Bedienpersonals ist so einfach auf einem solchen Simulator möglich.

Moderne Entwicklungsumgebungen, wie Sie bei der Motoren-, Antriebsstrang-, Getriebe-, Fahrzeugkomponenten- oder Fahrzeugentwicklung eingesetzt werden, gehen aber weit über ein bloßes Automatisierungssystem zur Steuerung eines Prüfstandes hinaus. Insbesondere werden neben der Prüfstandsautomatisierung noch weitere Entwicklungswerkzeuge benötigt, die gewünschte Auswertungen von vom Prüfstand oder vom Prüfling erhaltenen Daten ermöglichen. Diese Daten werden dabei in Realität von bestimmten Messgeräten erfasst und sind in der Regel für die Automatisierung irrelevant, sondern werden hauptsächlich für die Entwicklungsaufgabe benötigt. Z.B. ist ein Motor als Prüfling eines Prüfstandes mit einer Reihe von Messgeräten, z.B. Indiziergeräte mit Zylinderdruckaufnehmern, Emissionsmessgeräte, Verbrauchsmessgeräte, etc., ausgestattet, die für die Entwicklung eine Vielzahl von Motordaten (z.B. der Verbrennung, Emissionsdaten, Verbrauchsdaten, etc.) während eines Testlaufes erfassen. Diese erfassten Daten müssen für die Entwicklung des Motors natürlich in Abhängigkeit vom Betrieb des Motors (also in Abhängigkeit des Automatisierungssystems) entsprechend ausgewertet werden. Ein anderes Beispiel benötigter Entwicklungstools sind Kalibrierungstools. Die Kalibrierung z.B. der Motorsteuerung ist dabei eine multidimensionale Aufgabe, bedingt durch die immer weiter steigende Anzahl von Aktuatoren und Variationsparametern. Weitere Tools sind Auswertetools mit denen die Ergebnisse der unterschiedlichen Entwicklungstools gemeinsam ausgewertet und nachverarbeitet werden.

Eine Entwicklungsumgebung erfordert daher ein einwandfreies Zusammenspielen der Automatisierungsumgebung mit den daneben benötigten Entwicklungswerkzeugen. Insbesondere da eine Entwicklungsaufgabe einen in sich abgestimmten Arbeitsablauf der beteiligten Systeme benötigt und die verarbeiteten Daten alle aus dem Prüfstand oder dem Prüfling herrühren.

Die bloße Simulation der Automatisierungsumgebung, wie aus dem Stand der Technik bekannt, reicht daher nicht aus, um die Konfiguration und den Arbeitsablauf komplexer Entwicklungsumgebungen simulieren zu können. Dazu müssen die erzeugten Daten für das Automatisierungssystem und für die Entwicklung aufeinander abgestimmt sein, um die Entwicklungsumgebung durchgehend simulieren zu können, um Plausibilitätsprüfungen zu ermöglichen und um die Wiederholbarkeit von Testläufen gewährleisten zu können.

Es ist daher eine Aufgabe der gegenständlichen Erfindung, eine Vorrichtung und ein Verfahren anzugeben, mit dem die Konfiguration einer und der Arbeitsablauf in einer Entwicklungsumgebung mit einen Prüfstand für einen Prüfling und einem realen Automatisierungssystem vollständig simuliert werden kann.

Diese Aufgabe wird erfindungsgemäß dadurch gelöst, dass in der Entwicklungsanlage eine Anzahl von realen Entwicklungswerkzeugen und in der Simulationseinrichtung Entwicklungsdaten erzeugende, das Verhalten von Datenerfassungseinrichtungen simulierende Gerätemodelle vorgesehen sind, wobei die Gerätemodelle zumindest teilweise Simulationsdaten aus dem Prüfmodell verarbeiten und die Entwicklungswerkzeuge über reale Schnittstellen mit der Automatisierungseinrichtung und/oder der Simulationseinrichtung verbunden sind und die Entwicklungswerkzeuge die Entwicklungsdaten verarbeiten. Die Entwicklungswerkzeuge erhalten damit Daten, die mittels geeigneter Gerätmodelle für Messgeräte aus Daten der Prüfstands- bzw. Prüflingssimulation erzeugt werden. Damit werden die Entwicklungswerkzeuge und die Automatisierungseinrichtung mit in der Simulation aufeinander abgestimmten, konsistenten Daten versorgt. Damit kann die Konfiguration der oder ein Arbeitsablauf in der Entwicklungsumgebung durchgehend getestet bzw. simuliert werden. Insbesondere wird es dadurch auch möglich den gesamten Vorgang von der Datenerfassung bis zur Datenevaluierung zu simulieren. Dies stellt weiters die Reproduzierbarkeit eines Testlaufes und eine (auch nachträglich) mögliche Plausibilitätsprüfung des Ergebnisses sicher.

Vorteilhaft kann ein Hostsystem vorgesehen sein, das mit der Entwicklungsanlage verbunden wird, wodurch es möglich ist, über das Hostsystem Prüfabläufe über geeignete Bedienschnittstellen zu generieren und zu verwalten und/oder Prüfdaten oder Prüfabläufe zu speichern oder auszuwerten und/oder vorgegebene Prüfabläufe oder Konfigurationsdaten auf die Entwicklungsanlage zu spielen und/oder mehrere Entwicklungsanlagen oder Prüfstände zu einer Prüffabrik miteinander zu verbinden. Dazu wird besonders vorteilhaft im Hostsystem ein Datenspeicher vorgesehen, was eine einfache Reproduzierbarkeit eines Testlaufes ermöglicht.

Eine bestimmte Konfiguration einer Simulationseinrichtung mit sämtlichen Prüfmodellen, Gerätemodellen, Hardware Simulatoren kann sehr einfach mittels eines Simulationskonfigurators erfolgen, wodurch die Konfiguration und Parametrierung der Simulationumgebung vereinfacht wird. Eine weitere Vereinfachung kann erzielt werden, wenn im Simulationskonfigurator eine Prüf- und/oder Gerätemodelldatenbank vorgesehen ist, da dann vorgefertigte Teile nur mehr zusammengestellt und gegebenenfalls parametriert werden müssen.

Bestimmte Prüfstands Hardware, wie z.B. eine Belastungsmaschine, lässt sich durch Prüfmodelle nicht ausreichend modellieren, z.B. wegen einer hohen Komplexität der Hardware oder wegen des hochdynamischen Verhaltens der Hardware im realen Betrieb. Um auch solche Hardware hinreichend realitätsnahe in die Simulation einbinden zu können, ist in der Simulationseinrichtung bevorzugt ein Hardware Simulator zur Simulation dieser Prüfstandshardware vorgesehen. Mit einem solchen Hardware Simulator kann das reale Verhalten besser simuliert werden, als mit einem Softwaremodell.

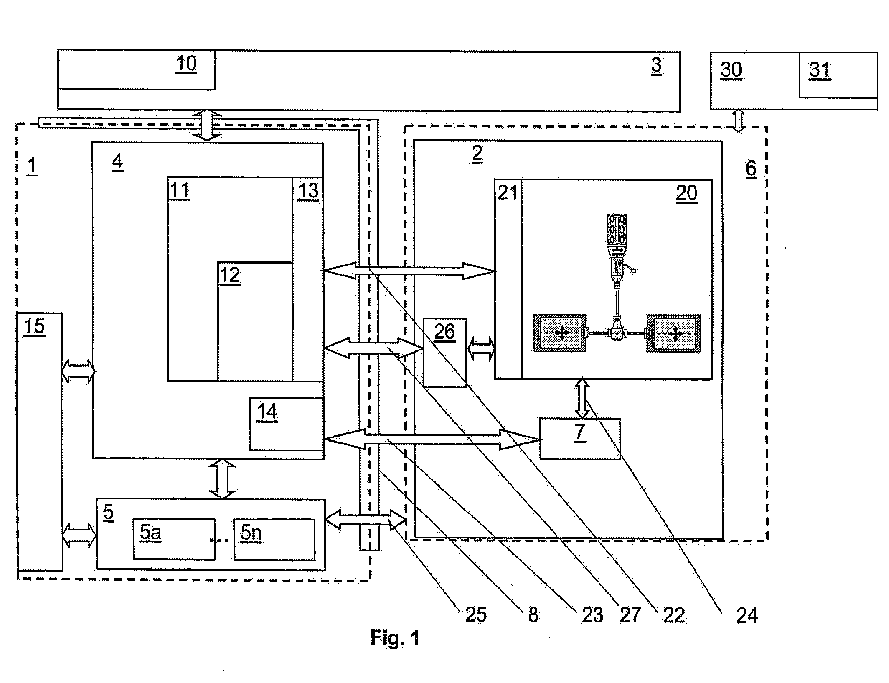

Die gegenständliche Erfindung wird im Nachfolgenden anhand der schematischen, nicht einschränkenden, ein bevorzugtes Ausführungsbeispiel zeigende Figur 1 beschrieben, die ein Blockdiagramm einer Entwicklungsumgebung mit simulierter Prüfstandsumgebung zeigt.

Eine Entwicklungsumgebung ist beispielhaft in Fig. 1 dargestellt und umfasst eine Entwicklungsanlage 1 und einen Prüfstand 2. Die Entwicklungsanlage 1 umfasst eine Automatisierungseinrichtung 4 und eine Anzahl von Entwicklungswerkzeugen 5, wie z.B. Messdatenauswertung, Kalibrierwerkzeuge, Indiziermesstechnik, etc. Die Automatisierungseinrichtung 4 kann dabei je nach Anwendung unterschiedliche Komponenten in verschiedenster Kombination enthalten, wie z.B. in diesem Beispiel eine Fahrzeugsimulation 11, eine Steuerung 12 von Belastungsmaschinen (Dynamometer) und/oder eines Motors, Schnittstellen 13 zum Prüfstand 2, Gerätetreiber 14 für angeschlossene Messgeräte, etc. Der Entwicklungsanlage 1 übergeordnet kann ein Hostsystem 3 sein, das z.B. dazu dient, Prüfabläufe über geeignete Bedienschnittstellen zu generieren und zu verwalten, Prüfdaten oder Prüfabläufe in einem Datenspeicher 10 zu speichern und auszuwerten, gespeicherte Prüfabläufe oder Konfigurationsdaten auf die Entwicklungsanlage 1 zu spielen, mehrere Entwicklungsanlagen 1 oder Prüfstände zu einer Prüffabrik miteinander zu verbinden, etc.

Mit einer solchen Entwicklungsanlage 1 soll in der Realität ein auf einem geeigneten Prüfstand 2 befindlicher Prüfling, z.B. hier wie angedeutet ein kompletter Antriebsstrang, entwickelt bzw. weiterentwickelt oder einem bestimmten Prüflauf, wie z.B. ein Dauertest, unterworfen werden. Um die Konfiguration der Entwicklungsanlage 1 vorab testen zu können, ist vorgesehen den Prüfstand 2 mit allen erforderlichen Komponenten nicht real aufzubauen, sondern zu simulieren. Dazu ist eine Simulationseinrichtung 6, z.B. eine geeignete Simulationshardware, z.B. dSpace^{®}, vorgesehen, in der die Komponenten des Prüfstandes 2, wie z.B. Motor, Getriebe, Differential, Wellen und Achsen, Dynamometer, etc., in Form von geeigneten Prüfmodellen 20 nachgebildet werden. Die Prüfmodelle 20 können z.B. mathematische, physikalische Modelle sein und können z.B. in Matiab/Simulink^{®} implementiert sein. In der möglichen Implementierung der Prüfmodelle 20 und der Simulationshardware gibt es allerdings keinerlei Einschränkungen.

Die Entwicklungsanlage 1 und die Simulationseinrichtung 6 sind über eine Schnittstelle 8 verbunden. Diese Schnittstelle 8 entspricht dabei der realen Schnittstelle der Entwicklungsanlage 1, was es ermöglicht, die Entwicklungsanlage 1 in ihrer realen Konfiguration zu testen. Über diese Schnittstelle 8 steuert die Automatisierungseinrichtung 4 den Prüfstand 2 beziehungsweise Komponenten davon und bekommt Daten (z.B. Messdaten) vom Prüfstand 2 bzw. von einzelnen Prüfstandskomponenten retour. Dazu sind in Realität am Prüfstand 2 entsprechende Datenerfassungseinrichtungen 21, wie z.B. Messgeräte, angeordnet. In der Simulationseinrichtung 6 werden diese Datenerfassungseinrichtungen 21 zur Erfassung und Generierung der Simulationsdaten 22 durch die Prüfmodelle 20 nachgebildet.

Insbesondere zur Anbindung von Belastungsmaschinen, wie z.B. Dynamometer, können in der Simulationseinrichtung 6 auch Hardware Simulatoren (z.B. APA/FAGA- Simulatoren) 26 eingesetzt werden. Auf diesen Hardware Simulatoren 26 können hochdynamische Regler, wie z.B. schnelle Bremsenregler, wie im realen Betrieb des Prüfstandes 2 laufen. Die Dynamik der simulierten Hardware, z.B. einer Belastungsmaschine, wird somit unabhängig von der Schnittstelle im Simulationsmodell 20 simuliert. Damit ist es einerseits möglich, die Software und Hardware der Entwicklungsanlage 1 in realer Weise zu verwenden, andererseits kann die Dynamik bestimmter Hardware, wie z.B. einer Belastungsmaschine, an die reale Prüfstandsdynamik angepasst werden. Der Hardware Simulator 26 kann über die Schnittstelle 8 Hardwaresimulationsdaten 27 an die Entwicklungsanlage 1 liefern. Der Hardware Simulator 26 kann dazu bei Bedarf auch mit Daten aus den Prüfmodellen 20 versorgt werden.

Neben den Simulationsdaten 22 für die Automatisierungseinrichtung 4, benötigt die Entwicklungsanlage 1 für die Bearbeitung in den benötigten Entwicklungswerkzeugen 5 auch noch weitere Daten, in Folge Entwicklungsdaten 23 genannt. Diese Entwicklungsdaten 23 können in den Prüfmodellen 20 generierte Simulationsdaten 22 sein, sind aber in der Regel Daten, die von der Automatisierungseinrichtung 4, also für die Regelung und Steuerung des Prüfstandes 2, nicht benötigt werden. Diese Entwicklungsdaten 23 werden aber sehr wohl direkt vom Prüfstand 2 bzw. von Prüfstandskomponenten oder dem Prüfling erzeugt und hängen damit von den Simulationsdaten 22 ab. Die Abhängigkeit ist dabei so zu verstehen, dass ein bestimmter Prüfstands- bzw. Prüflingszustand natürlich auch bestimmte Entwicklungsdaten 23 bedingt. Um die gesamte Entwicklungsanlage 1 mit einer Prüfstandssimulation testen zu können, ist es daher erforderlich, dass die Simulationsdaten 22 und die Entwicklungsdaten 23 zueinander passend und konsistent sind. Um das zu gewährleisten, sind in der Simulationseinrichtung 6 Gerätemodelle 7 implementiert, die das Verhalten weiterer Datenerfassungseinrichtungen, wie z.B. weiterer Messgeräte, simulieren. Diese Gerätemodelle 7 haben dabei als Input Simulationsdaten 24 aus den Prüfmodellen 20. Diese Simulationsdaten 24 können dabei (zumindest teilweise) gleichzeitig auch Simulationsdaten 22 sein, die mit der Automatisierungseinrichtung 4 ausgetauscht werden. Außerdem ist es natürlich auch möglich, dass die Gerätemodelle 7 noch weiteren Input erhalten, zum Beispiel andere interne oder externe Datenquellen. Die in den Gerätemodellen 7 generierten Entwicklungsdaten 23 gelangen über die Schnittstelle 8 der Entwicklungsanlage 1 und über gegebenenfalls vorhandene Gerätetreiber 14 zur Entwicklungsanlage 1, beziehungsweise über interne Schnittstellen in der Entwicklungsanlage 1 zu den Entwicklungswerkzeugen 5. Selbstverständlich ist es auch möglich, dass die Entwicklungswerkzeuge 5 über die Schnittstelle 8 direkt mit der Simulationseinrichtung 6 zum Austausch von Simulationsdaten und/oder Entwicklungsdaten 25 verbunden sind.

Die Simulationseinrichtung 6 kann durch einfaches Konfigurieren an die unterschiedlichen Prüfstandstypen, z.B. Motorprüfstand, Getriebeprüfstand, Rollenprüfstand angepasst werden. Es können also unterschiedliche Prüfstandskomponenten in Form von Prüfmodellen 20 und Gerätemodellen 7 kombiniert und entsprechend den Anforderungen parametriert werden. Damit kann die Entwicklungsanlage 1 für unterschiedliche Entwicklungszwecke und unterschiedliche Prüfstandtypen simuliert werden. Dazu kann z.B. auch ein Simulationskonfigurator 30 mit entsprechenden I/O-Einheiten, z.B. ein PC, vorgesehen sein. In diesem können in einer Prüf- und/oder Gerätemodelldatenbank 31 Modelle bestimmter Prüfstandstypen und/oder Komponenten davon und/oder bestimmter Messgeräte hinterlegt sein, die abgerufen, kombiniert und parametriert werden können. Der Simulationskonfigurator 30 kann dabei selbstverständlich auch in das Hostsystem 3 integriert sein.

In der Entwicklungsumgebung kann auch eine grundsätzlich bekannte I/O-Schnittstelle 15, mit entsprechenden Eingabe- und/oder Ausgabegeräten, vorgesehen sein, über die die Automatisierungseinrichtung 4 und/oder die Entwicklungswerkzeuge 5 und/oder der Prüfstand 2 angesprochen, gesteuert oder ein Feedback von diesen Komponenten zurückgegeben werden kann. Solche I/O-Schnittstellen 15 sind aus realen Entwicklungsumgebungen und auch aus vielen anderen Anwendungen bekannt. Über eine solche I/O-Schnittstelle 15 kann folglich auch der Prüfstand 2, bzw. in der Simulation die Simulationseinrichtung 6, gesteuert werden. Die I/O-Schnittstelle 15 kann dabei als Mensch-Maschine-Schnittstelle, aber auch als Maschine-Maschine-Schnittstelle ausgeführt sein. Eine solche I/O-Schnittstelle 15 könnte z.B. eine hinlänglich bekannte
- Einrichtung für ein Audio-Feedback, wie z.B. eine Sprachausgabe zur Ausgabe von z.B. Messwerten oder Betriebsparametern oder eine Ausgabe von akustischen Signalen, wie z.B. akustische Warnsignale, Töne, etc., und/oder
- Einrichtung zur akustischen Befehlseingabe, wie z.B. durch Spracherkennung, Pfiffe, Klatschen oder ähnliches, und/oder
- Einrichtung für ein visuelles Feedback, wie z.B. eine Bildausgabe, ein parameterabhängiges Einfärben von Bildschirmbereichen, eine Steuerung einer Arbeitsplatzbeleuchtung, Blinklichter, Anzeige-Ampeln, etc, und/oder
- Einrichtung zur optischen Eingabe, wie z.B. durch Pupillenbeobachtung, durch die Erfassung der Bewegung bestimmter Körperteile wie einer Hand oder eines Armes, durch Laserpointer, etc., und/oder
- Einrichtung zum haptischen Feedback, z.B. durch das Vibrieren eines Steuerhebels, durch Bewegung eines Sitzes oder eines Hebels, etc., und/oder
- Einrichtung zur mechanischen Eingabe, wie z.B. durch Knöpfe, Hebel, Regler, Tastatur, Computermaus, Touchscreens, etc., und/oder
- Einrichtung zum thermischen Feedback, wie z.B. durch Temperaturänderung eines Steuerhebels oder eines Sitzes, etc.
umfassen. Die I/O-Schnittstelle 15 kann dabei über die Automatisierungseinrichtung 4 und/oder die Entwicklungswerkzeuge 5 mit entsprechenden Signalen oder Daten versorgt werden oder diesen Komponenten Signale oder Daten senden. Selbstverständlich kann die I/O-Schnittstelle 15 auch direkt Daten aus dem Prüfstand 2 bzw. der Simulationseinrichtung 6, wie z.B. Simulationsdaten 22 oder Entwicklungsdaten 23, empfangen und weiterverarbeiten. Über eine solche I/O-Schnittstelle 15 ist eine beliebige, einfache und an die jeweilige Anwendung anpassbare Steuerung der oder eine einfache Ausgabe von Signalen oder Daten aus der Entwicklungsanlage, bzw. einzelner Teile davon, möglich.

## Patentansprüche

1. Vorrichtung zur Simulation der Konfiguration und des Arbeitsablaufes in einer Entwicklungsumgebung, wobei die Vorrichtung eine Entwicklungsanlage (1) für einen Prüfstand (2) für einen Prüfling und eine Simulationseinrichtung (6) umfasst, wobei in der Entwicklungsanlage (1) eine reale Automatisierungseinrichtung (4) zum Betrieb des Prüfstandes (2) vorgesehen ist, der Prüfling in der Simulationseinrichtung (6) mittels eines Simulationsdaten (22, 24) erzeugenden Prüfmodells (20) nachgebildet ist und die Automatisierungseinrichtung (4) und die Simulationseinrichtung (6) über reale Schnittstellen (8) der Entwicklungsanlage (1) verbunden sind und die Automatisierungseinrichtung (4) erzeugte Simulationsdaten (22) verarbeitet, **dadurch gekennzeichnet, dass** der Prüfstand (2) in der Simulationseinrichtung (6) mittels eines Simulationsdaten (22, 24) erzeugenden Prüfmodells (20) nachgebildet ist, **dass** in der Entwicklungsanlage (1) eine Anzahl von realen Entwicklungswerkzeugen (5) und in der Simulationseinrichtung (6) Entwicklungsdaten (23, 25) erzeugende, das Verhalten von Datenerfassungseinrichtungen simulierende Gerätemodelle (7) vorgesehen sind, wobei die Gerätemodelle (7) zumindest teilweise Simulationsdaten (24) aus dem Prüfmodell verarbeiten **und dass** die Entwicklungswerkzeuge (5) über reale Schnittstellen mit der Automatisierungseinrichtung (4) und/oder der Simulationseinrichtung (6) verbunden sind und die Entwicklungswerkzeuge (5) die Entwicklungsdaten (23, 25) verarbeiten.

2. Vorrichtung nach Anspruch 1, **dadurch gekennzeichnet, dass** ein Hostsystem (3) vorgesehen ist, das mit der Entwicklungsanlage (1) verbunden ist.

3. Vorrichtung nach Anspruch 2, **dadurch gekennzeichnet, dass** im Hostsystem (3) ein Datenspeicher (10) vorgesehen ist.

4. Vorrichtung nach einem der Ansprüche 1 bis 3, **dadurch gekennzeichnet, dass** ein Simulationskonfigurator (30) vorgesehen ist.

5. Vorrichtung nach Anspruch 4, **dadurch gekennzeichnet, dass** im Simulationskonfigurator (30) eine Prüf- und/oder Gerätemodelldatenbank (31) vorgesehen ist.

6. Vorrichtung nach einem der Ansprüche 1 bis 5, **dadurch gekennzeichnet, dass** in der Simulationseinrichtung (6) ein Hardware Simulator (26) zur Simulation bestimmter Prüfstandshardware vorgesehen ist.

7. Vorrichtung nach einem der Ansprüche 1 bis 6, **dadurch gekennzeichnet, dass** eine I/O-Schnittstelle (15) vorgesehen ist, die mit der Automatisierungseinrichtung (4) und/oder mit einem Entwicklungswerkzeug (5) und/oder mit Simulationseinrichtung (6) verbunden ist.

8. Verfahren zur Simulation der Konfiguration und des Arbeitsablaufes in einer Entwicklungsumgebung, die eine Entwicklungsanlage (1) für einen Prüfstand (2) für einen Prüfling und eine Simulationseinrichtung (6) umfasst, wobei der Prüfstand (2) mittels einer realen Automatisierungseinrichtung (4) betrieben wird und der Prüfling in der Simulationseinrichtung (6) mittels eines Simulationsdaten (22, 24) erzeugenden Prüfmodells (20) nachgebildet wird und wobei die Automatisierungseinrichtung (4) und die Simulationseinrichtung (6) über reale Schnittstellen (8) der Entwicklungsanlage (1) verbunden werden und die Automatisierungseinrichtung (4) erzeugte Simulationsdaten (22) verarbeitet, **dadurch gekennzeichnet, dass** der Prüfstand (2) in der Simulationseinrichtung (6) mittels eines Simulationsdaten (22, 24) erzeugenden Prüfmodells (20) nachgebildet wird, **dass** in der Simulationseinrichtung (6) Entwicklungsdaten (23, 25) erzeugende, das Verhalten von Datenerfassungseinrichtungen simulierende Gerätemodelle (7) laufen, wobei die Gerätemodelle (7) zumindest teilweise Simulationsdaten (24) aus dem Prüfmodell (20) verarbeiten **und dass** eine Anzahl von realen Entwicklungswerkzeugen (5) der Entwicklungsanlage (1) über reale Schnittstellen mit der Automatisierungseinrichtung (4) und/oder der Simulationseinrichtung (6) verbunden werden und die Entwicklungswerkzeuge (5) die Entwicklungsdaten (23) verarbeiten.

9. Verfahren nach Anspruch 8, **dadurch gekennzeichnet, dass** in der Simulationseinrichtung (6) bestimmte Prüfstandshardware in einem Hardware Simulator (26) simuliert wird.

10. Verfahren nach Anspruch 8 oder 9, **dadurch gekennzeichnet, dass** mit einem Simulationskonfigurator (30) eine Konfiguration einer Simulationseinrichtung (6) erzeugt wird.

11. Verfahren nach einem der Ansprüche 8 bis 10, **dadurch gekennzeichnet, dass** über ein Hostsystem (3) Prüfabläufe über geeignete Bedienschnittstellen generiert und verwaltet werden und/oder Prüfdaten oder Prüfabläufe gespeichert oder ausgewertet werden und/oder gespeicherte Prüfabläufe oder Konfigurationsdaten auf die Entwicklungsanlage (1) gespielt werden und/oder mehrere Entwicklungsanlagen (1) oder Prüfstände (2) zu einer Prüffabrik miteinander verbunden werden.

12. Verfahren nach einem der Ansprüche 8 bis 11, **dadurch gekennzeichnet, dass** über eine I/O-Schnittstelle (15) Daten oder Signale an die Automatisierungseinrichtung (4) und/oder an ein Entwicklungswerkzeug (5) und/oder an die Simulationseinrichtung (6) gesendet oder davon empfangen werden.

## Claims

1. A device for the simulation of the configuration and of the process in a development environment, comprising a development system (1) for a test bench (2) for a unit under test and a simulation device (6), wherein a real automation device (4) is provided in the development system (1) for the operation of the test bench (2), the unit under test is simulated in the simulation device (6) by means of a test model (20) generating simulation data (22, 24), and the automation device (4) and the simulation device (6) are connected to each other via real interfaces (8) of the development system (1), and the automation device (4) processes generated simulation data (22), **characterized in that** the test bench (2) is simulated in the simulation device (6) by means of a test model (20) generating simulation data (22, 24), **in that** a number of real development tools (5) are provided in the development system (1), and a number of device models (7) generating development data (23, 25) and simulating the behavior of data collection devices are provided in the simulation device (6), wherein the device models (7) at least partially process simulation data (24) from the test model, **and that** the development tools (5) are connected to the automation device (4) and/or to the simulation device (6) via real interfaces, and that the development tools (5) process the development data (23, 25).

2. The device according to claim 1, **characterized in that** a host system (3) is provided, which is connected to the development system (1).

3. The device according to claim 2, **characterized in that** a database (10) is provided in the host system (3).

4. The device according to one of the claims 1 to 3, **characterized in that** a simulation configurator (30) is provided.

5. The device according to claim 4, **characterized in that** a test and/or device model database (31) is provided in the simulation configurator (30).

6. The device according to one of the claims 1 to 5, **characterized in that** a hardware simulator (26) is provided in the simulation device (6) for the simulation of certain test bench hardware.

7. The device according to one of the claims 1 to 6, **characterized in that** an I/O interface (15) is provided, which is connected to the automation device (4) and/or to a development tool (5) and/or to the simulation device (6).

8. A method for the simulation of the configuration and of the process in a development environment, comprising a development system (1) for a test bench (2) for a unit under test and a simulation device (6), wherein the test bench (2) is operated by means of a real automation device (4), and the unit under test is simulated in the simulation device (6) by means of a test model (20) generating simulation data (22, 24), and wherein the automation device (4) and the simulation device (6) are connected to each other via real interface (8) of the development system (1), and the automation device (4) processes generated simulation data (22), **characterized in that** the test bench (2) is simulated in the simulation device (6) by means of a test model (20) generating simulation data (22, 24), **in that** device models (7) generating development data (23, 25) and simulating the behavior of data collection devices run in the simulation device (6), wherein the device models (7) at least partially processes simulation data (24) from the test model (20), **and that** a number of real development tools (5) of the development system (1) is connected to the automation device (4) and/or the simulation device (6) via real interfaces, and that the development tools (5) process the development data (23).

9. The method according to claim 8, **characterized in that** certain test bench hardware is simulated in the simulation device (6) in a hardware simulator (26).

10. The method according to claims 8 or 9, **characterized in that** a configuration of a simulation device (6) is created utilizing a simulation configurator (30).

11. The method according to one of the claims 8 to 10, **characterized in that** test processes are generated and managed and/or test data or test processes are stored or analyzed and/or stored test processes or configuration data are loaded on the development system (1) and/or multiple development systems (1) or test benches (2) are connected to each other to form a test facility via a host system by means of suitable user interfaces.

12. The method according to one of the claims 8 to 11, **characterized in that** data or signals are transmitted to the automation device (4) and/or to a development tool (5) and/or to the simulation device (6), or received by the same, via an I/O interface (15).

## Revendications

1. Dispositif de simulation de la configuration et de la séquence de travail dans un environnement de développement, dans lequel le dispositif comprend une installation de développement (1) pour un banc d'essai (2) destiné à une éprouvette et un équipement de simulation (6), dans lequel un équipement d'automatisation (4) réel pour le fonctionnement du banc d'essai (2) est prévu dans l'installation de développement (1), l'éprouvette est reproduite dans l'équipement de simulation (6) à l'aide d'un modèle d'essai (20) produisant des données de simulation (22, 24), et l'équipement d'automatisation (4) et l'équipement de simulation (6) sont reliés par des interfaces (8) réelles de l'installation de développement (1), et l'équipement d'automatisation (4) traite des données de simulation (22) produites,
**caractérisé en ce que** le banc d'essai (2) dans l'installation de simulation (6) est reproduit au moyen d'un modèle d'essai (20) produisant des données de simulation (22, 24), **en ce que** dans l'installation de développement (1) un certain nombre d'outils de développement (5) réels est prévu, et dans l'équipement de simulation (6) des modèles d'appareils (7) produisant des données de développement (23, 25) et simulant le comportement d'équipements de collecte de données sont prévus, les modèles d'appareils (7) traitant au moins partiellement des données de simulation (24) provenant du modèle d'essai, et **en ce que** les outils de développement (5) sont reliés par des interfaces réelles à l'équipement d'automatisation (4) et/ou à l'équipement de simulation (6) et les outils de développement (5) traitent les données de développement (23, 25).

2. Dispositif selon la revendication 1, **caractérisé en ce qu'**il est prévu un système hôte (3) qui est relié à l'installation de développement (1).

3. Dispositif selon la revendication 2, **caractérisé en ce qu'**une mémoire de données (10) est prévue dans le système hôte (3).

4. Dispositif selon l'une quelconque des revendications 1 à 3, **caractérisé en ce qu'**il est prévu un configurateur de simulation (30).

5. Dispositif selon la revendication 4, **caractérisé en ce qu'**une banque de données de modèles d'essai et/ou de modèles d'appareils (31) est prévue dans le configurateur de simulation (30).

6. Dispositif selon l'une quelconque des revendications 1 à 5, **caractérisé en ce qu'**un simulateur matériel (26) pour la simulation de certains éléments matériels de banc d'essai est prévu dans l'équipement de simulation (6).

7. Dispositif selon l'une quelconque des revendications 1 à 6, **caractérisé en ce qu'**il est prévu une interface d'E/S (15) qui est reliée à l'équipement d'automatisation (4) et/ou à un outil de développement (5) et/ou à l'équipement de simulation (6).

8. Procédé de simulation de la configuration et de la séquence de travail dans un environnement de développement comprenant une installation de développement (1) pour un banc d'essai (2) destiné à une éprouvette et un équipement de simulation (6), dans lequel le banc d'essai (2) est actionné au moyen d'un équipement d'automatisation (4) réel, et l'éprouvette est reproduite dans l'équipement de simulation (6) au moyen d'un modèle d'essai (20) produisant des données de simulation (22, 24), et dans lequel l'équipement d'automatisation (4) et l'équipement de simulation (6) sont reliés par des interfaces (8) réelles de l'installation de développement (1), et l'équipement d'automatisation (4) traite des données de simulation (22) produites,
**caractérisé en ce que** le banc d'essai (2) est reproduit dans l'installation de simulation (6) au moyen d'un modèle d'essai (20) produisant des données de simulation (22, 24), **en ce que** dans l'équipement de simulation (6) fonctionnent des modèles d'appareils (7) produisant des données de développement (23, 25) et simulant le comportement d'équipements d'acquisition de données, les modèles d'appareils (7) traitant au moins partiellement des données de simulation (24) provenant du modèle d'essai, et **en ce qu'**un certain nombre d'outils de développement (5) réels de l'installation de développement (1) sont reliés par des interfaces réelles à l'équipement d'automatisation (4) et/ou à l'équipement de simulation (6), et les outils de développement (5) traitent les données de développement (23).

9. Procédé selon la revendication 8, **caractérisé en ce que** certains éléments matériels de banc d'essai sont reproduits dans l'équipement de simulation (6) par un simulateur matériel (26).

10. Procédé selon la revendication 8 ou 9, **caractérisé en ce qu'**un configurateur de simulation (30) produit une configuration d'un équipement de simulation (6).

11. Procédé selon l'une quelconque des revendications 8 à 10, **caractérisé en ce qu'**un système hôte (3) produit et gère des séquences d'essais via des interfaces de service adéquates et/ou mémorise ou analyse des données d'essai ou des séquences d'essais et/ou installe des séquences d'essais mémorisées ou des données de configuration sur l'installation de développement (1) et/ou réunit plusieurs installations de développement (1) ou bancs d'essai (2) en un centre d'essais.

12. Procédé selon l'une quelconque des revendications 8 à 11, **caractérisé en ce que** des données ou des signaux à destination et en provenance de l'équipement d'automatisation (4) et/ou d'un outil de développement (5) et/ou de l'équipement de simulation (6) sont envoyées ou reçues par l'intermédiaire d'une interface d'E/S (15).
